# EUROPEAN PATENT APPLICATION

(11) **EP 1 542 522 A2**
(43) Date of publication of application: **15.06.2005**
(21) Application number: 04028873.0
(22) Date of filing: 06.12.2004
(51) Int. Cl.: H05K 7/20, B62M 1/00

(54) **Heat dissipating apparatus for a bicycle electronic component**

(30) Priority: 08.12.2003 JP 2003408969
(71) Applicant: Shimano Inc., Osaka 590-8577 (JP)
(72) Inventor: Kitamura, Satoshi, Kitakatsuragi Nara (JP); Ishikawa, Noriyasu, Sakai Osaka (JP)
(74) Representative: Grosse, Wolfgang, Dipl.-Ing.

(57) **Abstract**

A heat dissipating apparatus for a bicycle electronic component comprises an electronic component 52 that generates heat; a case 11 having a thermally conductive portion, wherein the electronic component 52 is supported by the case 11, and wherein the case 11 includes a structure for mounting the case 11 to a bicycle; and a thermally conductive member disposed between the electronic component 52 and the case 11.

## Description

### BACKGROUND OF THE INVENTION

The present invention is directed to bicycles and, more particularly, to a heat dissipating apparatus for a bicycle electronic component.

In recent years, bicycles have been equipped with many electronic components in order to provide various desirable functions. Such components are disclosed in Japanese Kokai Publication Nos. 9-213852 and 2002-83912. For example, bicycles may be equipped with motor drive circuits structured to operate a gearshift motor for a bicycle transmission and/or structured to operate a suspension control motor for a bicycle suspension. Bicycles also frequently are equipped with control circuits used to control the operation of headlights mounted to the bicycle. Circuits used to control such devices may include one or more high speed CPU's mounted to a control substrate. Some control circuits may include overvoltage protection circuits that stabilize voltage applied to the various circuits and devices from a power supply such as a battery or an alternating current generator that converts the rotation of a wheel to electrical energy. Overvoltage protection circuits are particularly useful to protect against excessive voltage that may be generated by an alternating current generator during high speed riding.

Many electronic components provided for bicycles comprise elements such as diodes, transistors, etc. that generate significant amounts of heat during operation. For example, voltage prevention circuits use Zener diodes and transistors to absorb a portion of the load placed on a headlight, and such electronic components generate large amounts of heat. In conventional bicycles, no measures are taken for dissipating the heat generated by such heat-generating elements. Thus, there is the danger that excessive heat generated by the heat-generating elements will alter the operating characteristics of the electronic components or destroy the electronic components altogether, thereby creating electronic component malfunctions and the like.

### SUMMARY OF THE INVENTION

The present invention is directed to various features of a bicycle electronic component. In one embodiment, a heat dissipating apparatus for a bicycle electronic component comprises an electronic component that generates heat; a case having a thermally conductive portion, wherein the electronic component is supported by the case and the case includes a structure for mounting the case to a bicycle; and a thermally conductive member disposed between the electronic component and the case. Additional inventive features will become apparent from the description below, and such features alone or in combination with the above features may form the basis of further inventions as recited in the claims and their equivalents.

### BRIEF DESCRIPTION OF THE DRAWINGS

Fig. 1 is a side view of a particular embodiment of a bicycle;
Fig. 2 is a schematic block diagram of a portion of an overall bicycle control device;
Fig. 3(A) is a side view of a particular embodiment of a control box;
Fig. 3(B) is a plan view of the control box;
Fig. 4 is a detailed view of a particular embodiment of a heat dissipating structure;
Fig. 5(A) is a schematic block diagram of a particular embodiment of an overvoltage prevention circuit;
Fig. 5(B) is a schematic block diagram of a particular embodiment of a motor driver circuit; and
Fig. 5(C) is a schematic block diagram of a particular embodiment of a CPU mounted to a control substrate.

### DETAILED DESCRIPTION OF THE EMBODIMENTS

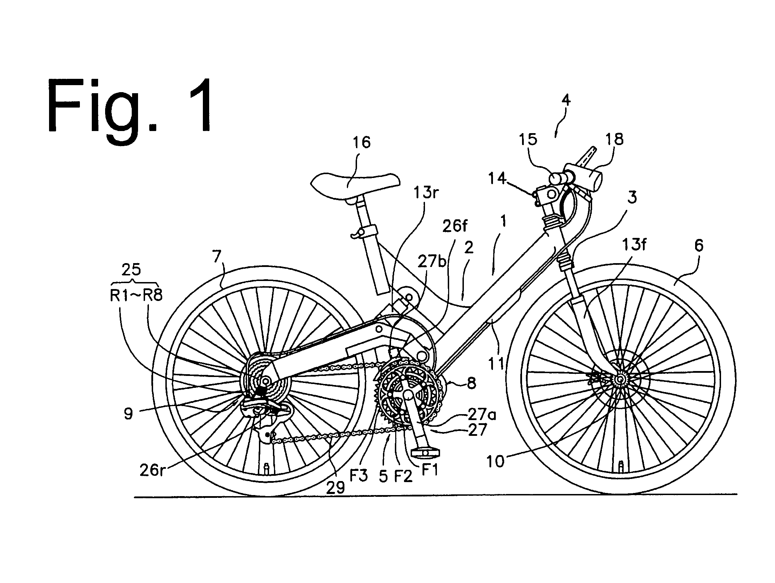

Fig. 1 is a side view of a particular embodiment of a bicycle 1. In this embodiment, bicycle 1 is a trekking bicycle that comprises a frame body 2 constructed by welding together tubing having different shapes. A front fork 3 is mounted to the front of frame body 2 for rotation around an inclined axis, and a handlebar assembly 4 is mounted to the top of front fork 3. Handlebar assembly 4 comprises a handlebar stem 14 and a handlebar 15, wherein handlebar stem 14 is mounted to the upper portion of fork 3, and handlebar 15 is mounted to the upper portion of handlebar stem 14. Brake lever assemblies and grips are mounted on opposite sides of handlebar 15, wherein a shift control device (not shown) is integrated with the right side brake lever assembly. A headlight 18 is mounted to a central portion of handlebar 15.

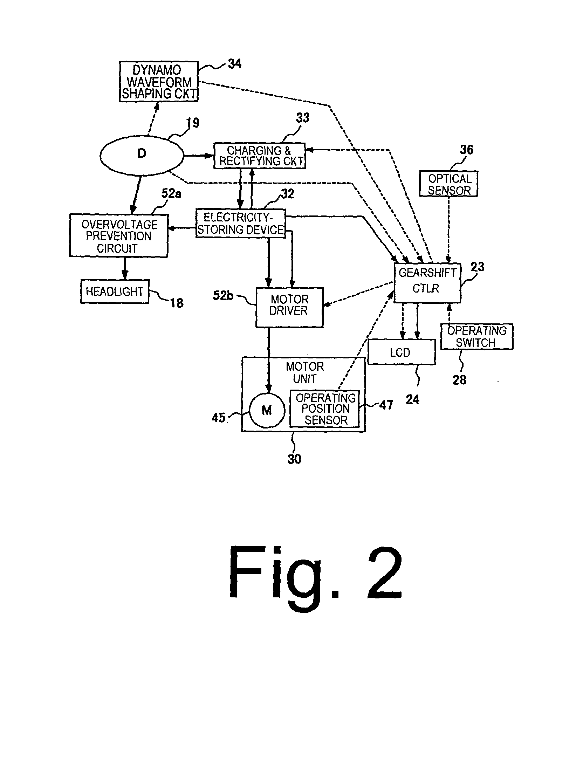

A saddle 16 is mounted to the upper middle part of frame body 2, a drive mechanism 5 is mounted to the lower part of frame body 2, a front wheel 6 having a hub dynamo 10 and possibly a roller brake is rotatably mounted to the bottom of front fork 3, and a rear wheel 7 is rotatably mounted to the rear of frame body 2. Hub dynamo 10 houses an alternating current generating dynamo 19 (Fig. 2) for generating electricity through rotation of front wheel 6. A front transmission 8 including a front derailleur 26f is mounted to the lower middle part of frame body 2, and a rear transmission 9 including a rear derailleur 26r is mounted to the rear of frame body 2. A front suspension 13f is mounted to front fork 3, and a rear suspension 13r is mounted between stationary and articulated portions of frame body 2.

Drive mechanism 5 comprises a crank 27 rotatably mounted at the bottom bracket of frame body 2, front and rear transmissions 8 and 9, and a chain 29. Front transmission 8 comprises, for example, three front sprockets F1-F3 and front derailleur 26f. Front sprockets F1-F3 are mounted to crank 27, and front derailleur 26f is mounted on frame body 2. Rear transmission 9 comprises, for example, a multiple sprocket assembly 25 having eight rear sprockets R1-R8 and rear derailleur 26r. Multiple sprocket assembly 25 is mounted to rear wheel 7, and rear derailleur 26r is mounted at the back of frame body 2. Crank 27 comprises a right crank arm 27a and a left crank arm 27b, wherein front sprockets F1-F3 are mounted to right crank arm 27a. Chain 29 engages one of the front sprockets F1-F3 and one of the rear sprockets R1-R8.

Front sprockets F1-F3 are arranged in the order of an increasing number of teeth, wherein front sprocket F1 is the laterally innermost front sprocket having the least number of teeth, and front sprocket F3 is the laterally outermost front sprocket having the most number of teeth. Rear sprockets R1-R8 are arranged in the order of a decreasing number of teeth, wherein rear sprocket R1 is the laterally innermost rear sprocket having the most number of teeth, and rear sprocket R8 is the laterally outermost rear sprocket having the least number of teeth.

A rotation sensor (not shown) is provided for sensing the rotation of crank 27. The presence or absence of rotation of crank 27 ordinarily is used in part to control the operation of front and rear transmissions 8 and 9. For example, derailleurs cannot shift properly when crank 27 is stationary, so any requested operation of a derailleur may be delayed until crank 27 is rotating. A rotation sensor typically comprises a reed switch (not shown) mounted to frame body 2 and a plurality of (e.g., four) magnets (not shown) concentrically mounted to one of the crank arms 27a and 27b so that reed switch 23 provides four pulses for each revolution of crank 27.

A control box 11 containing various electronic components for controlling various components including front and rear transmissions 8 and 9, front and rear suspensions 13f and 13r and headlight 18 is mounted to frame body 2 between fork 3 and drive mechanism 5. More specifically, the components within control box 11 control front and rear transmissions 8 and 9 and front and rear suspensions 13f and 13r in response to the operation of gear switches and control switches (not shown) mounted to handlebar 15. The components within control box 11 also automatically control the operation of front and rear transmissions 8 and 9 in response to bicycle velocity. Headlight 18 is turned off and on in response to ambient light.

Fig. 2 is a schematic block diagram of the components used to control the operation of headlight 18 and one of the front and rear transmissions 8 and 9, for example. Heavy lines indicate lines carrying about 1A of current, *thin solid lines indicate lines carrying about 1mA of current, and broken lines indicate signal lines. The main relevant components comprise dynamo 19, a gearshift controller 23, a motor unit 30 for controlling the one of the front and rear transmissions 8 and 9, an overvoltage prevention circuit 52a connected between headlight 18 and dynamo 19, and a motor driver 52b.

An operating switch 28, a liquid crystal display (LCD) 24 and an optical sensor 36 are connected to gearshift controller 23. Operating switch 28 is used for requesting various operations of gearshift controller 23, LCD 24 is used for displaying various operating information, and optical sensor 36 serves as an ambient light sensor for controlling the operation of headlight 18.

A dynamo waveform shaping circuit 34 receives the alternating current signal from dynamo 19 and provides speed indicating signals to gearshift controller 23. More specifically, dynamo waveform shaping circuit 34 may perform half-period sampling of the alternating current sine wave signals, pass the sampled signals through an appropriate waveform shaping circuit such as a Schmitt circuit, and generate a pulsed signal corresponding to the speed of the bicycle.

A charging and rectifying circuit 33 also receives the alternating current signal from dynamo 19, coverts the alternating current signal to a direct current signal, and provides the direct current signal to an electricity storing device 32. Charging and rectifying circuit 33 may comprise a half-wave rectifying circuit that rectifies the alternating current from dynamo 19 into direct current and supplies the direct current to the electricity-storing device 32.

Electricity storing device 32 provides operating power to gearshift controller 23, charging and rectifying circuit 33, overvoltage prevention circuit 52a and motor driver 52b. Approximately 1mA of electric current is supplied to gearshift controller 23, motor driver 52b and charging and rectifying circuit 33. Approximately 1A of electric current is supplied directly to motor driver 52b. Electricity storing device 32 may comprise, for example, a high capacity capacitor. Electricity-storing device 32 also may comprise a secondary battery, such as a nickel-cadmium battery, lithium-ion battery, nickel-hydride battery, etc., instead of a capacitor.

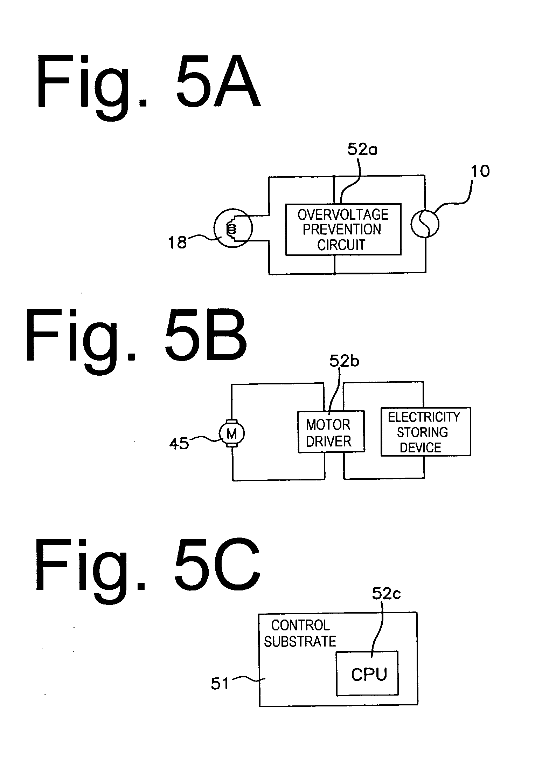

Overvoltage prevention circuit 52a is used to prevent excessive voltage generated by dynamo 19 from being applied to headlight 18. Overvoltage prevention circuit 52a accomplishes this by converting a portion of a high voltage generated by dynamo 19 to thermal energy while bicycle 1 is traveling at high speed. Overvoltage prevention circuit 52a comprises a Zener diode and various transistors. As shown in Fig. 5 (a), overvoltage prevention circuit 52a is connected in parallel with dynamo 19 and headlight 18. Headlight 18 is turned on by electrical energy that dynamo 19 generates when front wheel 6 rotates. When bicycle 1 travels at high speed, the electrical energy generated by dynamo 19 increases, thus increasing the load placed on headlight 18 and significantly shortening the life of headlight 18. The Zener diode in overvoltage protection circuit 52a stabilizes the voltage to a proper lever, thus preventing damage to headlight 18. However, undesirably large amounts of heat are generated by the Zener diode and other heat-generating elements in overvoltage prevention circuit 52a to accomplish such protection. A solution to this problem is discussed below.

Motor unit 30 comprises a gear shifting motor 45 and an operating position sensor 47. Motor 45 moves one of the front derailleur 26f or rear derailleur 26r. Operating position sensor 47 senses the operating position of the relevant front derailleur 26f or rear derailleur 26r, and this operating position information is provided to gearshift controller 23. Of course, motor unit 30 could be used to operate one of front suspension 13f or 13r, in which case motor 45 would be a suspension control motor.

Motor driver 52b performs positioning control for gear-shifting motor 45. Motor driver 52b comprises various transistors, such as an FET and the like. As shown in Fig. 5 (b), motor driver 52b is connected to electricity storing device 32 and gear-shifting motor 45. Motor driver 52b operates on the approximately 1mA of electric current supplied from electricity storing device 32 and directs the approximately 1A of electric current supplied from electricity-storing device 32 to gear-shifting motor 45. Since a relatively large current flows through motor driver 52b, the voltage drops of the transistors and other heat-generating elements generate a substantial amount of heat. A solution to this problem also is discussed below.

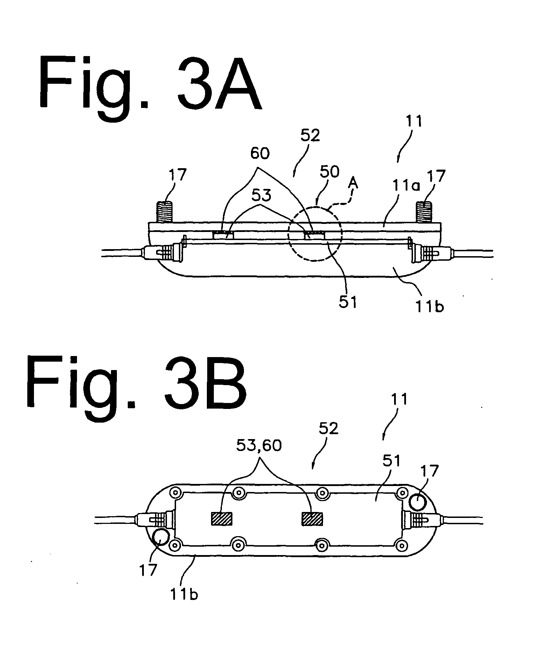

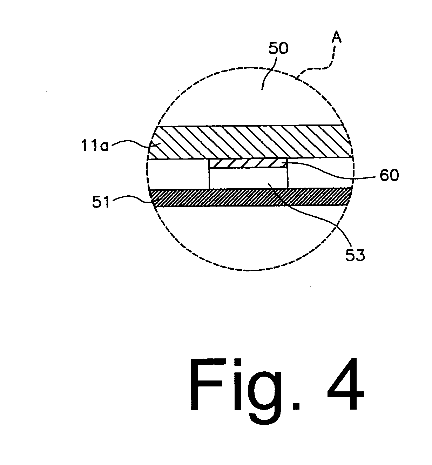

Fig. 3(A) is a side view of a particular embodiment of control box 11, Fig. 3(B) is a plan view of control box 11, and Fig. 4 is a detailed view of a particular embodiment of a heat dissipating structure 50. Control box 11 (an example of a case) comprises a lid 11a and a main body 11b, both of which are made of a lightweight material having a relatively high coefficient of thermal conductivity such as an aluminum alloy. Mounting bolts 17 mount control box 11 to bolt holes (not shown) formed in frame body 2 of bicycle 1. Supported and housed within control box 11 are various electronic components 52, such as a control substrate 51, overvoltage prevention circuit 52a, motor driver 52b, and a high speed CPU 52c (Fig. 5(C)) that forms a part of gearshift controller 23. CPU 52c also generates heat as it functions. Overvoltage prevention circuit 52a, motor driver 52b and CPU 52c may be mounted on control substrate 51. The heat generating elements within these circuits are designated generally as 53, and they contact lid 11a of control box 11 through a thermally conductive member such as a thermally conductive sheet 60. Lid 11a of case 11, heat generating elements 53 and thermally conductive sheet 60 form a heat dissipating structure 50.

In this embodiment, thermally conductive sheet 60 is a relatively soft, thin and flexible member formed using copper or aluminum to facilitate contact with heat generating elements 53 and lid 11a of control box 11 over a relatively large area. Since thermally conductive sheet 60 makes contact with both the heat-generating elements 53 comprising the electronic components 52 (i.e., the Zener diode of overvoltage prevention circuit 52a, the transistors in motor driver 52b and CPU 52c, etc.) and lid 11a of control box 11 through a large area, the heat generated inside the electronic components 52 can be efficiently dissipated. As a result, fluctuations in operating characteristics of the electronic components or heat destruction of the electronic components can be avoided. Heat dissipation is further enhanced by the fact that control box 11 is mounted in a location on bicycle 1 as shown in Fig. 1 where it will be subjected to wind during riding.

While the above is a description of various embodiments of inventive features, further modifications may be employed without departing from the spirit and scope of the present invention. For example, while electronic components 52 such as overvoltage prevention circuit 52a, motor driver 52b and high speed CPU 52c shown in Figs. 5 (A)-5(C) were provided as examples of electronic components that generate heat, the teachings herein could be applied to any heat generating components.

While control box 11 was mounted to frame body 2 of bicycle 1, control box 11 could be mounted most anywhere on bicycle 1. For example, control box 11 also could be mounted to handlebar 15 or to a basket mounted somewhere on bicycle 1. While control box 11 was made of an aluminum alloy in the described embodiment, copper or some other metal with a high coefficient of thermal conductivity also could be used to form at least the heat dissipating part of control box 11.

While bicycle 1 was described as a trekking bike, clearly the teachings herein could be applied to any type of bicycle, such as a mountain bike, sport bike or some other bicycle.

The size, shape, location or orientation of the various components may be changed as desired. Components that are shown directly connected or contacting each other may have intermediate structures disposed between them. The functions of one element may be performed by two, and vice versa. The structures and functions of one embodiment may be adopted in another embodiment. It is not necessary for all advantages to be present in a particular embodiment at the same time. Every feature which is unique from the prior art, alone or in combination with other features, also should be considered a separate description of further inventions by the applicant, including the structural and/or functional concepts embodied by such feature(s). Thus, the scope of the invention should not be limited by the specific structures disclosed or the apparent initial focus or emphasis on a particular structure or feature.

## Claims

1. A heat dissipating apparatus for a bicycle electronic component, wherein the apparatus comprises:
an electronic component (52) that generates heat;
a case (11) having a thermally conductive portion, wherein the electronic component (52) is supported by the case (11), and wherein the case (11) includes a structure for mounting the case (11) to a bicycle (1); and
a thermally conductive member disposed between the electronic component (52) and the case (11).

2. The apparatus according to claim 1 wherein the case (11) is formed from an aluminum alloy.

3. The apparatus according to claim 1 or 2 wherein the electronic component (52) is disposed within the case (11).

4. The apparatus according to any of the preceding claims wherein the thermally conductive member comprises a thermally conductive sheet (60).

5. The apparatus according to any of the preceding claims wherein the thermally conductive member comprises copper.

6. The apparatus according to any of claims 1 to 4 wherein the thermally conductive member comprises aluminum.

7. The apparatus according to any of the preceding claims wherein the electronic component (52) comprises an overvoltage prevention circuit (52a).

8. The apparatus according to claim 7 wherein the overvoltage protection circuit (52a) is structured to provide overvoltage protection from a voltage generated by a bicycle dynamo (19).

9. The apparatus according to claim 7 wherein the overvoltage protection circuit (52a) is structured to provide overvoltage protection for a bicycle headlight (18).

10. The apparatus according to any of the preceding claims wherein the electronic component (52) comprises a motor drive circuit.

11. The apparatus according to claim 10 wherein the motor drive circuit is structured to operate a gearshift motor for a bicycle transmission (8, 9).

12. The apparatus according to claim 10 wherein the motor drive circuit is structured to operate a suspension control motor for a bicycle suspension (13f, 13r).

13. The apparatus according to any of the preceding claims wherein the electronic component (52) comprises a central processing unit (52c).

14. The apparatus according to claim 13 wherein the central processing unit (52c) is mounted to a control substrate (51).

15. The apparatus according to claim 13 or 14 wherein the central processing unit (52c) is disposed between the control substrate (51) and the thermally conductive member.

16. The apparatus according to any of the preceding claims wherein the electronic component (52) is mounted to a control substrate (51).

17. The apparatus according to claim 16 wherein the electronic component (52) is disposed between the control substrate (51) and the thermally conductive member.

18. The apparatus according to claim 17 wherein the thermally conductive member is disposed between the electronic component (52) and the case (11).

19. The apparatus according to claim 18 wherein the thermally conductive member contacts the case (11).

20. The apparatus according to claim 18 wherein the thermally conductive member contacts the electronic component (52).

21. The apparatus according to claim 18 wherein the thermally conductive member contacts the case (11) and the electronic component (52).
